# EUROPÄISCHE PATENTSCHRIFT

(11) **EP 2 282 944 B1**
(45) Veröffentlichungstag und Bekanntmachung des Hinweises auf die Patenterteilung: **31.10.2012**
(21) Anmeldenummer: 08874178.0
(22) Anmeldetag: 25.11.2008
(51) Int. Cl.: B65B 41/00, B65B 41/06, B65B 43/46, B65B 69/00, B65G 1/127, B65G 29/02, H01L 21/677, H01L 25/00

(54) **VORRICHTUNG ZUM EIN- ODER AUSPACKEN ODER SORTIEREN VON WAFERN**
DEVICE FOR PACKING OR UNPACKING OR SORTING WAFERS
DISPOSITIF D'EMBALLAGE OU DE DÉBALLAGE OU DE TRI DE TRANCHES

(30) Priorität: 06.05.2008 AT 7182008
(43) Veröffentlichungstag der Anmeldung: 16.02.2011
(73) Patentinhaber: Mechatronic Systemtechnik GmbH, 9500 Villach (AT)
(72) Erfinder: SCHOBER, Walter, A-9073 Viktring (AT)
(74) Vertreter: Jell, Friedrich
(86) Internationale Anmeldenummer: PCT/EP2008/066098
(87) Internationale Veröffentlichungsnummer: WO 2009/135543

(56) Entgegenhaltungen:
- DE-A1- 2 547 819
- DE-C1- 19 626 635

## Beschreibung

Die Erfindung betrifft eine Vorrichtung zum Ein- oder Auspacken von stapelbaren Gegenständen, wie von Wafern, insbesondere Siliziumwafern, in oder aus Transportbehältern, oder zum Sortieren von stapelbaren Gegenständen, wie Wafern, insbesondere Siliziumwafern, in Transportbehältern, wobei mehrere Magazine vorgesehen sind, die jeweils Verpackungsmaterial oder Transportbehälter aufnehmen können, und wobei ein Roboter vorgesehen ist, der stapelbare Gegenstände aus Transportbehältern entnehmen oder in Transportbehälter einlegen kann.

Die Erfindung wird vorteilhaft bei Halbleiterscheiben, sogenannten Siliziumwafern, angewendet, kann aber auch auf entsprechende Scheiben (Wafer) aus anderem Material angewendet werden, die ähnliche Abmessungen haben, etwa für Solarzellen.

Die Erfindung kann aber ganz allgemein auf stapelbare Gegenstände (Schachteln, Kisten, Kataloge, Bücher, ...) angewendet werden, die in Transportbehälter eingeordnet, aus diesen entnommen oder die einfach sortiert werden sollen.

Siliziumwafer werden als Standardwafer mit einem Durchmesser von 24-300mm und einer Dicke von 275-775mm gefertigt. Um den Durchsatz bei der Produktion zu erhöhen, werden in der Regel Durchmesser von etwa 300mm bevorzugt. Unabhängig vom Durchmesser können aber auch dünne Wafer hergestellt und mit der erfindungsgemäßen Vorrichtung bearbeitet werden, deren Dicke bis auf 50mm abgesenkt wird.

Beim Verpackungsprozess von Wafern werden verschiedene Verpackungsmaterialien benötigt, die jeweils in eigenen Magazinen aufbewahrt werden. So werden in der Regel zwischen zwei Wafer Trennblätter gelegt und auf bzw. unter den letzten Wafer Dämpfungsschichten gelegt, z.B. Schaumstoffschichten, um die Wafer beim Transport in der Transportbox zu schützen. Ein Transportbehälter kann dabei einen oder mehrere Wafer enthalten.

Die in Transportbehälter zu verpackenden Wafer selbst sind in Behältern abgelegt, meist in einem sogenannten FOUP (Front Opening Unified Pod). Ein FOUP ist ein geschlossener Behälter, der nur innerhalb der jeweiligen Prozess- oder Messanlagen an der Vorderseite geöffnet wird und gleichsam einen kleinen abgekapselten Reinraum darstellt. Ein FOUP beinhaltet typischerweise 20-30 Wafer.

Die Wafer werden beim Verpacken von einem Roboter aus den jeweiligen Behältern (FOUPs) entnommen und in den Transportbehälter geschichtet. Die Verpackungsmaterialen werden beim Verpacken von einem Greifer, z.B. einem Vakuumgreifer (Chuck) aus den jeweiligen Magazinen entnommen und ebenfalls in den Transportbehälter geschichtet. Beim Auspacken aus dem Transportbehälter werden das Verpackungsmaterial vom Greifer und die Wafer vom Roboter schichtweise herausgenommen und in die entsprechenden Magazine bzw. Behälter (FOUPs) gelegt.

Bei den bisher bekannten Vorrichtungen zum Ein- oder Auspacken von Wafern sind die Magazine linear hinter- bzw. nebeneinander angeordnet. Die Magazine müssen bei diesen Vorrichtungen oft von drei Seiten beladen werden. Da die Öffnungen zum Beladen der Vorrichtung in einem Reinraum angeordnet sein müssen, ist eine Standfläche im Reinraum mit den Abmessungen der Vorrichtung selbst (z.B. 1500x2300mm) plus zumindest 1 m Spielraum zum Beladen und Entladen der Vorrichtung vorzusehen, insgesamt also etwa z.B. 3500x3300mm.

Die lineare Anordnung der Magazine bedingt auch einen langsameren Verpackungsprozess durch die großen Distanzen zwischen den Magazinen, die ein oder mehrere Roboter zurücklegen müssen und durch die häufige Waferübergabe.

Aus der DE2547819A1 ist eine Speichereinrichtung zur Speicherung von Werkstücken etc. bekannt. Diese Speichereinrichtung umfasst hierfür Träger, die um eine gemeinsame waagrechte Drehachse drehbar und in der gleichen senkrechten Ebene angeordnet sind. Die Träger bilden Aufnahmeflächen für Werkstücke aus.

Die DE19626635C1 zeigt weiter einen Patemosterschrank, in dessen Trageinheiten Behälter eingeschoben werden können.

Eine Aufgabe der Erfindung ist es daher, eine Vorrichtung zur Verfügung zu stellen, die weniger Platz, insbesondere in Reinraumatmosphäre, benötigt.

Dies wird gemäß Anspruch 1 dadurch erreicht, dass mehrere Magazine um eine gemeinsame waagrechte Achse drehbar und in der gleichen senkrechten Ebene angeordnet sind. Dadurch, dass die Magazine gleichsam wie auf einem Rad montiert sind, können die Magazine mit den Transportbehältern durch Drehung zum Roboter, der die Wafer einlegt bzw. herausnimmt, hinbewegt werden. Ebenso können die Magazine mit den Verpackungsmaterialen zu den Greifern hingedreht werden bzw. die Transportbehälter können zu den Greifern hin bewegt werden, wo das aufgenommene Verpackungsmaterial in den Transportbehälter eingelegt wird.

Aufgrund der erfindungsgemäßen Anordnung der Magazine ist es möglich, dass nur eine Öffnung zum Be- und Entladen der Magazine in der Vorrichtung vorgesehen ist. Der bekannte Stand der Technik weist wie eingangs erwähnt mehrere Öffnungen für die Be- und Entladung der Magazine auf.

Eine konstruktiv besonders einfache Ausführungsform der Erfindung sieht vor, dass zwei identische Drehsterne vorgesehen sind, die mehrere von der Drehachse radial nach außen verlaufende Arme aufweisen, und zumindest ein Magazin zwischen diesen Drehsternen, insbesondere zwischen einem Arm des ersten und einem Arm des zweiten Drehsterns, befestigt ist.

Um sicherzustellen, dass die Magazine in jeder Stellung horizontal ausgerichtet sind, kann vorgesehen werden, dass die Drehachsen der beiden Drehsterne zwar parallel, aber gegeneinander verschoben sind. Die Drehachsen der beiden Drehsterne liegen also nicht auf der gleichen waagrechten Achse, sondern die Drehachse des ersten Drehsterns befindet sich beispielsweise in derselben horizontalen Ebene wie jene des zweiten Drehsterns, aber nach vorne oder hinten verschoben. Allerdings bleiben die Drehachsen der beiden Drehsterne parallel zueinander, damit sie eine gemeinsame Drehung durchführen können.

Dies kann wiederum besonders einfach gelöst werden, indem der erste Drehstern angetrieben ist und der zweite Drehstern vom ersten Drehstern angetrieben wird.

Um das Verpackungsmaterial bewegen zu können, ist vorgesehen, dass oberhalb der Magazine zumindest ein Greifer angeordnet ist, der Verpackungsmaterial anheben bzw. ablegen kann. Im einfachsten Fall ist dies ein Vakuumgreifer. Durch die Anordnung oberhalb der Magazine kann ebenfalls Platz gespart werden.

Um die Gegenstände, insbesondere Wafer, bearbeiten (z.B. Wafer in einem Prealigner ausrichten) oder zwischenzeitlich ablegen zu können, kann vorgesehen werden, dass neben den Magazinen eine Ablagfläche angeordnet ist, wo stapelbare Gegenstände abgelegt oder bearbeitet werden können.

Ein besonders schnelles und einfaches Verfahren zum Betrieb einer erfindungsgemäßen Vorrichtung beim Verpacken von stapelbaren Gegenständen, wie Wafern, insbesondere Siliziumwafern, besteht darin, dass in einer ersten Position der Magazine aus einem Magazin mit Verpackungsmaterial ein Stück Verpackungsmaterial entnommen wird, in einer zweiten Position das entnommene Verpackungsmaterial in einen leeren Transportbehälter gelegt wird, in einer dritten Position in den nun gefüllten Transportbehälter mittels des Roboters ein Gegenstand eingelegt wird, in einer vierten Position aus einem Magazin mit Verpackungsmaterial ein weiteres Stück Verpackungsmaterial entnommen wird, in einer fünften Position das entnommene Verpackungsmaterial auf den Gegenstand im Transportbehälter gelegt wird.

Wenn dabei ein Magazin mit dem Transportbehälter so angeordnet ist, dass gleichzeitig aus einem anderen Magazin mit Verpackungsmaterial ein Stück Verpackungsmaterial entnommen werden kann, dann können die Schritte von dritter und vierter Position gleichzeitig ausgeführt werden, dritte und vierte Position sind identisch.

Analog ist es beim Auspacken von Gegenständen, wie Wafern aus Transportbehältern, dabei ist vorgesehen, dass: in einer ersten Position der Magazine ein Stück Verpackungsmaterial aus einem Transportbehälter entnommen wird, in einer zweiten Position das entnommene Verpackungsmaterial in ein Magazin für Verpackungsmaterial abgelegt wird, in einer dritten Position der Gegenstand mittels des Roboters aus dem Transportbehälter entnommen wird, in einer vierten Position aus dem Transportbehälter ein weiteres Stück Verpackungsmaterial entnommen wird, in einer fünften Position das weitere Stück Verpackungsmaterial in einem Magazin für Verpackungsmaterial abgelegt wird.

Bei entsprechender Anordnung der Magazine kann wieder erreicht werden, dass zweite und dritte Position identisch sind und somit die für diese Positionen vorgesehenen Schritte gleichzeitig durchgeführt werden.

Beim Sortieren von stapelbaren Gegenständen, wie Wafern, insbesondere Siliziumwafern, geht es darum, die Gegenstände in einer anderen Reihenfolge in den gleichen oder in einen oder mehrere andere gleichartige Transportbehälter einzuordnen, im Sinne der obigen Beschreibung also um einen Vorgang des Auspackens gefolgt von einem Vorgang des Verpackens. In diesem Sinne können die vorgenannten Schritte entsprechend kombiniert werden. So könnten etwa Gegenstände aus einem ersten Transportbehälter auf mehrere andere Transportbehälter aufgeteilt werden, die durch entsprechende Drehung in eine Stellung gebracht werden, in welcher der Roboter den Gegenstand in einen bestimmten Transportbehälter einlegen kann.

Falls Gegenstände behandelt werden, die ohne Verpackungsmaterial aufeinander gestapelt werden können, so vereinfacht sich das Auspacken bzw. Verpacken, weil die Schritte betreffend das Verpackungsmaterial weggelassen werden können.

Ein Ausführungsbeispiel der Erfindung ist in den Figuren dargestellt und wird im Folgenden erläutert. Dabei zeigen:
Fig. 1 zeigt eine Ansicht der Magazine in einer drehbaren Anordnung,
Fig. 2 zeigt schematisch eine mögliche Position der Magazine,
Fig. 3 zeigt eine Draufsicht auf eine erfindungsgemäße Vorrichtung.

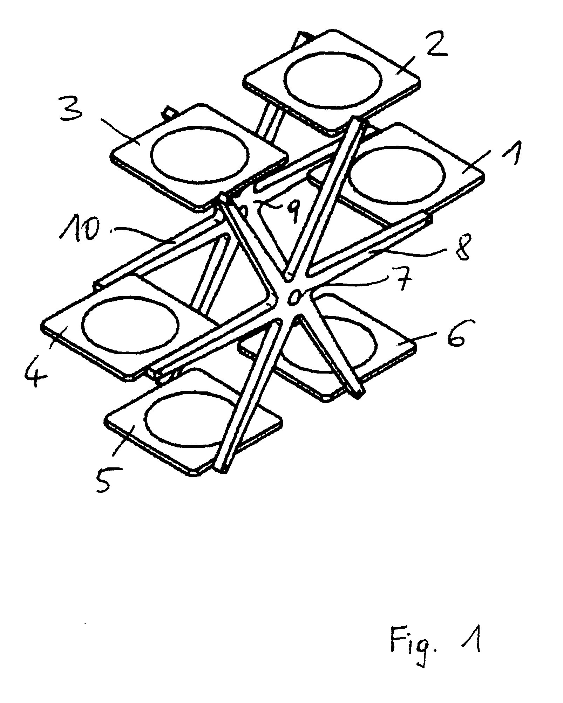

In Fig. 1 ist schematisch die Anordnung von sechs Magazinen 1-6 gezeigt. Die Magazine sind im Wesentlichen quadratische Platten, auf die Behälter mit Verpackungsmaterialen bzw. einzelne Transportbehälter gestellt werden können. Jedes Magazin 1-6 ist drehbar mit jeweils einem Arm 8, 10 der beiden Drehsterne 7, 9 verbunden.

Die Drehachsen der Drehsterne 7, 9 stehen senkrecht zur Ebene der Drehsterne und sind somit waagrecht ausgerichtet. Allerdings sind die Drehachsen in horizontaler Ebene etwas gegeneinander verschoben, aber immer noch parallel. Die Drehachse des ersten Drehsterns 7 liegt daher weiter vorne als jene des zweiten Drehsterns 9. Dadurch ist sichergestellt, dass die Magazine 1-6 in jeder Stellung waagrecht ausgerichtet sind, ohne dass dafür weitere konstruktive Maßnahmen notwendig wären.

Die Verschiebung der Drehachsen gegeneinander ist auch aus dem Ort der Befestigung der Arme 8, 10 an den Magazinen 1-6 ersichtlich: die Arme 8 des ersten Drehsterns 7 sind vor der Mitte der Magazine an den Magazinen 1-6 befestigt, die Arme 10 des zweiten Drehsterns 9 greifen hinter der Mitte der Magazine 1-6 an.

Nicht dargestellt sind in Fig. 1 der Antrieb für den ersten Drehstern 7 und die Kopplung des ersten Drehsterns 7 mit dem zweiten Drehstern 9. Es sind verschiedene Kopplungen der beiden Drehsterne denkbar.

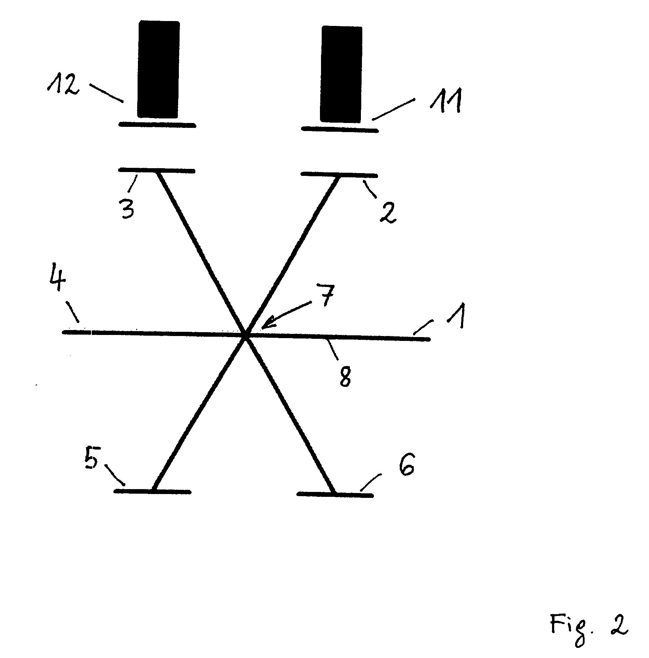

In Fig. 2 sind nochmals schematisch die Drehsterne, hier repräsentiert vom ersten Drehstern 7 mit seinen sechs Armen 8, und die Magazine 1-6 dargestellt. In dieser Darstellung sind auch die Greifer 11 und 12 zu erkennen, die als Vakuumgreifer ausgebildet sind, und die zum Anheben bzw. Ablegen von Verpackungsmaterial dienen. Diese sind so angeordnet, dass sie sich genau über den beiden Magazinen befinden, wenn diese ihre höchste Position erreicht haben. In der dargestellten Position sind dies die Magazine 2 und 3.

Der erste Greifer 11 ist zum Greifen von Trennblättern ausgebildet. Diese Trennblätter werden beim Verpacken zwischen zwei Wafer eingelegt. Der zweite Greifer 12 ist zum Greifen von Dämpfungsschichten, wie z.B. einer Schaumstoffschicht ausgebildet. Es wird jeweils zumindest eine Dämpfungsschicht auf den Boden des Transportbehälters und eine Dämpfungsschicht als letzte Schicht auf den Stapel aus Wafern gelegt, welche dann am Deckel des verschlossenen Transportbehälters anliegt. Die Drehachse der Drehsterne 7, 9 liegt im Schnittpunkt der Arme 8, 10 der Drehsterne.

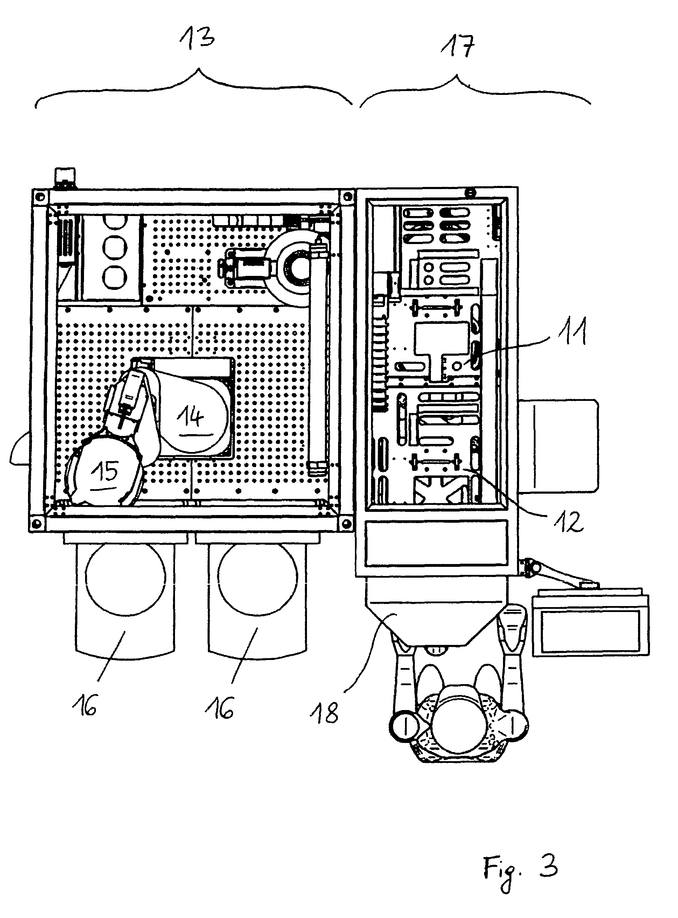

In Fig. 3 ist die Draufsicht auf eine erfindungsgemäße Vorrichtung dargestellt, bei welcher die Oberseite des Gehäuses abgenommen ist, sodass man in das innere sehen kann. Der linke Teil der Vorrichtung stellt einen sogenannten Prealigner 13 dar. Dieser weist eine ebene waagrechte Arbeitsfläche auf, die sich in etwa auf der gleichen Ebene wie die Drehachsen der beiden Drehsterne 7, 9 befindet, also bezüglich der Stellung der Drehsterne gemäß Fig. 2 auf der Höhe der beiden Magazine 1 und 4.

Auf der Arbeitsfläche ist ein Roboter mit einem Roboterarm 14 angeordnet. Am Ende des Roboterarms ist eine Einrichtung 15 zum Halten von Wafern. Die Behälter (FOUPs 16) für die zu verpackenden bzw. ausgepackten Wafer werden an der Vorderseite des Prealigners 13 angedockt.

Rechts neben dem Prealigner 13 ist das Gehäuse 17 für die erfindungsgemäße Anordnung der Magazine 1-6 vorgesehen. Von oben sind lediglich die beiden Greifer 11, 12 zu sehen. Das Gehäuse 17 hat an der Vorderseite eine Klappe 18, durch welche die Magazine beladen werden können. Das Gehäuse des Prealigners 13 und das Gehäuse 17 für die Magazine sind so miteinander verbunden, dass der Roboterarm 14 Wafer zu und von den Magazinen 1-6 fördern kann.

Ein möglicher Verpackungsvorgang kann - mit Bezug auf die Fig. 2 und 3 - so aussehen: Durch die Öffnung 18 werden Magazine 1 und 4 mit jeweils einem Transportbehälter beladen, die Magazine 2 und 5 mit Trennblättern und die Magazine 3 und 6 mit Schaumstoffschichten.

Zuerst wird in der in Fig. 2 dargestellten Position des Drehsterns 7 vom Greifer 12 eine Schaumstoffschicht aufgenommen. Dann wird der Drehstern 7 um ein Magazin im Uhrzeigersinn gedreht, sodass das Magazin 4 unterhalb des Greifers 12 zu stehen kommt. Der Greifer 12 legt nun die Schaumstoffschicht in den leeren Transportbehälter des Magazins 4. Das Magazin 4 wird nun wieder um ein Magazin gegen den Uhrzeigersinn zurückgedreht, sodass es sich wieder in der in Fig. 2 dargestellten Position befindet. Hier wird dann mittels des Roboterarms 14 ein Wafer aus einem FOUP 16 in das Magazin 4 auf die Schaumstoffschicht gelegt. Der Greifer 11 kann währenddessen ein Zwischenblatt aus dem Magazin 2 aufnehmen. Anschließend wird das Magazin 4 unter den Greifer 11 gedreht, wo der Greifer 11 ein Zwischenblatt auf den Wafer ablegt.

Es kann dann durch Drehen des Magazins 4 auf die ursprüngliche Position in Fig. 2 oder auf die Position des Magazins 1 in Fig. 2 gedreht werden, sodass ein weiterer Wafer eingelegt werden kann, dann wieder ein Zwischenblatt, und so weiter.

Sind alle Wafer in den Transportbehälter abgelegt worden, so wird das Magazin mit dem befüllten Transportbehälter unter den Greifer 12 bewegt, der zuvor eine Schaumstoffschicht aufgenommen hat, und die Schaumstoffschicht wird auf den letzten Wafer gelegt. Der Transportbehälter kann nun durch die Öffnung 18 wieder entnommen und verschlossen werden.

Analog läuft ein Verfahren ab, wo Wafer aus einem befüllten Transportbehälter ausgepackt und in FOUPs 16 umgepackt werden: die Schaumstoffschichten bzw. Trennblätter werden nach Drehen des Magazins mit dem befüllten Transportbehälter unter die Greifer 11, 12 aus dem Transportbehälter entnommen und von den Greifern in den entsprechenden Magazinen 2, 3, 5, 6 abgelegt, wobei die Magazine 2, 3, 5, 6 dazu entsprechend unter den Greifern 11, 12 positioniert werden.

Selbstverständlich können bei anderen Ausführungsformen mehr oder weniger Magazine zum Einsatz kommen, die Drehsterne können also mehr oder weniger Arme 8, 10 aufweisen.

Die Magazine müssen auch nicht an Armen 8, 10 befestigt sein, sondern können auch an einem Ring, der durch Speichen mit der Drehachse verbunden ist, befestigt sein.

Vorteilhaft an der erfindungsgemäßen Vorrichtung ist jedenfalls, dass durch die Anordnung der Magazine auf einer radförmigen Konstruktion nur ein Gehäuse von einer Magazinbreite benötigt wird und dadurch schon Platz in Form von teurer Reinraumfläche gespart wird.

Auch können dadurch alle Magazine von einer Seite befüllt werden, was ebenfalls Reinraumfläche einspart, weil nur auf einer Seite der Vorrichtung Platz für den Zugang zur Vorrichtung vorgesehen werden muss. Es muss auch nicht mehr die gesamte Vorrichtung im Reinraum angeordnet werden, sondern es ist ausreichend, nur die Vorderseite, von der aus die Magazine beladen werden, in der Reinraumwand einzubauen.

### Bezuqszeichen:

- 1: erstes Magazin
- 2: zweites Magazin
- 3: drittes Magazin
- 4: viertes Magazin
- 5: fünftes Magazin
- 6: sechstes Magazin
- 7: erster Drehstern
- 8: Arm des ersten Drehsterns 7
- 9: zweiter Drehstern
- 10: Arm des zweiten Drehsterns 9
- 11: erster Greifer
- 12: zweiter Greifer
- 13: Prealigner
- 14: Roboterarm
- 15: Einrichtung zum Halten von Wafern
- 16: FOUP
- 17: Gehäuse für Magazine
- 18: Klappe

## Patentansprüche

1. Vorrichtung zum Ein- oder Auspacken von stapelbaren Gegenständen, nämlich Wafern, insbesondere Siliziumwafern, in oder aus Transportbehältern oder zum Sortieren von stapelbaren Gegenständen, nämlich Wafern, insbesondere Siliziumwafern, in Transportbehältern, mit mehreren Magazinen (1-6), die jeweils Verpackungsmaterial oder Transportbehälter aufnehmen können, und mit einem einen Roboterarm (14) aufweisenden Roboter, der Wafer aus Transportbehältern entnehmen oder in Transportbehälter einlegen kann, **dadurch gekennzeichnet, dass** mehrere von einem Gehäuse (17) umfasste Magazine (1-6) um eine gemeinsame waagrechte Drehachse drehbar und in der gleichen senkrechten Ebene angeordnet sind, und dass die Vorrichtung einen neben dem Gehäuse (17) der Magazine (1-6) vorgesehenen Prealigner (13) aufweist, wobei der Prealigner (13) ein Gehäuse und eine ebene und waagrechte Arbeitsfläche aufweist, die sich in etwa auf der gleichen Ebene wie die Drehachse der Magazine (1-6) befindet und auf der der Roboter mit dem Roboterarm (14) angeordnet ist, wobei das Gehäuse des Prealigners (13) und das Gehäuse (17) für die Magazine (1-6) so miteinander verbunden sind, dass der Roboterarm (14) Wafer zu und von den Magazinen (1-6) fördern kann.

2. Vorrichtung nach Anspruch 1, **dadurch gekennzeichnet, dass** nur eine Öffnung zum Be- und Entladen der Magazine (1-6) in der Vorrichtung vorgesehen ist.

3. Vorrichtung nach Anspruch 1 oder 2, **dadurch gekennzeichnet, dass** zwei identische Drehsterne (7, 9) vorgesehen sind, die mehrere von der Drehachse radial nach außen verlaufende Arme (8, 10) aufweisen, und zumindest ein Magazin (1-6) zwischen diesen Drehsternen (7, 9), insbesondere zwischen einem Arm des ersten und einem Arm des zweiten Drehsterns, befestigt ist.

4. Vorrichtung nach Anspruch 3, **dadurch gekennzeichnet, dass** die Drehachsen der beiden Drehsterne (7, 9) zwar parallel, aber gegeneinander verschoben sind.

5. Vorrichtung nach Anspruch 4, **dadurch gekennzeichnet, dass** der erste Drehstern (7) angetrieben ist und der zweite Drehstern (9) vom ersten Drehstern angetrieben wird.

6. Vorrichtung nach einem der Ansprüche 1 bis 5, **dadurch gekennzeichnet, dass** oberhalb der Magazine (1-6) zumindest ein Greifer (11, 12) angeordnet ist, der Verpackungsmaterial anheben bzw. ablegen kann.

7. Vorrichtung nach einem der Ansprüche 1 bis 6, **dadurch gekennzeichnet, dass** sechs Magazine (1-6) vorgesehen sind.

8. Vorrichtung nach einem der Ansprüche 1 bis 7, **dadurch gekennzeichnet, dass** neben den Magazinen (1-6) eine Ablagefläche angeordnet ist, wo stapelbare Gegenstände abgelegt oder bearbeitet werden können.

9. Verfahren zum Betrieb einer Vorrichtung nach einem der Ansprüche 1 bis 8 zum Verpacken von stapelbaren Gegenständen, nämlich Wafern, insbesondere Siliziumwafern, in Transportbehälter, **dadurch gekennzeichnet, dass** in einer ersten Position der Magazine (1-6) aus einem Magazin mit Verpackungsmaterial ein Stück Verpackungsmaterial entnommen wird, in einer zweiten Position das entnommene Verpackungsmaterial in einen leeren Transportbehälter gelegt wird, in einer dritten Position in den nun gefüllten Transportbehälter mittels des Roboters ein Wafer eingelegt wird, in einer vierten Position aus einem Magazin mit Verpackungsmaterial ein weiteres Stück Verpackungsmaterial entnommen wird, in einer fünften Position das entnommene Verpackungsmaterial auf den Wafer im Transportbehälter gelegt wird.

10. Verfahren nach Anspruch 9, **dadurch gekennzeichnet, dass** dritte und vierte Position identisch sind.

11. Verfahren zum Betrieb einer Vorrichtung nach einem der Ansprüche 1 bis 8 zum Auspacken von stapelbaren Gegenständen, nämlich Wafern, insbesondere Siliziumwafem, aus Transportbehältern, **dadurch gekennzeichnet, dass** in einer ersten Position der Magazine (1-6) ein Stück Verpackungsmaterial aus einem Transportbehälter entnommen wird, in einer zweiten Position das entnommene Verpackungsmaterial in ein Magazin für Verpackungsmaterial abgelegt wird, in einer dritten Position der Wafer mittels des Roboters aus dem Transportbehälter entnommen wird, in einer vierten Position aus dem Transportbehälter ein weiteres Stück Verpackungsmaterial entnommen wird, in einer fünften Position das weitere Stück Verpackungsmaterial in einem Magazin für Verpackungsmaterial abgelegt wird.

12. Verfahren nach Anspruch 11, **dadurch gekennzeichnet, dass** zweite und dritte Position identisch sind.

## Claims

1. Apparatus for packing or unpacking stackable objects, namely wafers, in particular silicon wafers, into or out of transportation containers or for sorting stackable objects, namely wafers, in particular silicon wafers, in transportation containers, with a plurality of magazines (1-6), each of which is able to accommodate packing materials or transportation containers, and with a robot having one robotic arm (14), which can remove wafers from transportation containers or place them in transportation containers, wherein a plurality of magazines (1-6) enclosed in a housing (17) are rotationally arranged around a common horizontal axis of rotation and in the same vertical plane and in addition to the housing (17) for the magazines (1-6) provision is made for the apparatus to embody a prealigner (13), where the prealigner (13) has a housing and a level horizontal work surface, which is located roughly on the same level as the axis of rotation of the magazines (1-6) and arranged on that of the robot with the robotic arm (14), with the housing of the prealigner (13) and the housing (17) for the magazines (1-6) being connected to each other in such a manner that the robotic arm (14) is able to transport wafers to and from the magazines (1-6).

2. Apparatus according to Claim 1, wherein provision is made for only one opening in the apparatus for loading and unloading the magazines (1-6).

3. Apparatus according to either of Claims 1 or 2, wherein provision is made for two identical star wheels (7, 9) with a plurality of arms (8, 10) extending radially outward from the axis of rotation and at least one magazine (1-6) is fastened between these star wheels (7, 9), in particular between one arm of the first and one arm of the second star wheel.

4. Apparatus according to Claim 3, wherein the rotary axes of the two star wheels (7, 9) are parallel, but displaced in relation to each other.

5. Apparatus according to Claim 4, wherein the first star wheel (7) is powered and the second star wheel (9) is actuated by the first star wheel.

6. Apparatus according to any one of Claims 1 to 5, wherein at least one gripper (11, 12) is arranged above the magazines (1-6) and which can lift and/or set down the packing material.

7. Apparatus according to any one of Claims 1 to 6, wherein provision is made for six magazines (1-6).

8. Apparatus according to any one of Claims 1 to 7, wherein a horizontal surface is arranged next to the magazines (1-6), where stackable items can be stored or processed.

9. Method for operating an apparatus according to any one of Claims 1 to 8 for packing stackable items, namely wafers, in particular silicon wafers, in transportation containers, wherein in a first position of the magazines (1-6) one piece of packing material is taken from one magazine with packing material, in a second position the packing material removed is laid in an empty transportation container, in a third position a robot lays a wafer into the now filled transportation container, in a fourth position a further piece of packing material is taken from one magazine with packing material, in a fifth position the packing material removed is laid on the wafer in the transportation container.

10. Method according to Claim 9, wherein the third and fourth positions are identical.

11. Method for operating an apparatus according to any one of Claims 1 to 8 for unpacking stackable items, namely wafers, in particular silicon wafers, from transportation containers, wherein in a first position of the magazines (1-6) one piece of packing material is taken from one transportation container, in a second position the packing material removed is laid in a magazine for packing material, in a third position a robot removes the wafer from the transportation container, in a fourth position a further piece of packing material is taken from the transportation container, in a fifth position the further piece of packing material is placed in a magazine for packing material.

12. Method according to Claim 11, wherein the second and third positions are identical.

## Revendications

1. Dispositif pour l'emballage ou déballage d'objets empilables, à savoir des plaquettes, en particulier des plaquettes de silicium, de ou de vers des réservoirs de transport ou pour le tri d'objets empilables, à savoir des plaquettes, en particulier des plaquettes de silicium, dans des réservoirs de transport, avec plusieurs magasins (1-6), qui peuvent recevoir respectivement du matériel d'emballage ou des réservoirs de transport, et avec un robot, présentant un bras de robot (14), qui peut enlever des plaquettes de réservoirs de transport ou les y poser, **caractérisé en ce que** plusieurs magasins (1 -6), entourés d'un boîtier (17), orientables autour d'un axe horizontal commun et qui sont disposés dans le même plan perpendiculaire, et que le dispositif présente un pré-aligneur (13), prévu parallèlement au boîtier (17) des magasins (1-6), où le pré-aligneur (13) présente un boîtier et une surface de travail plane et horizontale, qui se trouve à peu près sur le même plan que l'axe rotatif des magasins (1-6), et sur lequel est disposé le robot avec le bras de robot (14), où le boîtier du pré-aligneur (13) et le boîtier (17) pour les magasins (1-6) sont assemblés entre eux de telle sorte, que le bras de robot(14) peut transporter des plaquettes à partir des et vers les magasins (1-6).

2. Dispositif d'après revendication 1, **caractérisé en ce qu'**une seule ouverture est prévue dans le dispositif pour le chargement et déchargement des magasins (1-6).

3. Dispositif d'après revendication 1 ou 2, **caractérisé en ce que** deux éléments rotatifs en étoile identiques (7, 9) sont prévus, qui présentent plusieurs bras, qui passent radialement de l'axe rotatif vers l'extérieur (8, 10), et au moins un magasin (1-6) qui est fixé entre ces éléments rotatifs en étoile (7, 9), en particulier entre un bras du premier et un bras du deuxième élément rotatif en étoile.

4. Dispositif d'après revendication 3, **caractérisé en ce que** les axes rotatifs des deux éléments rotatifs en étoile (7, 9) sont certes parallèles, mais décalés l'un contre l'autre.

5. Dispositif d'après revendication 4, **caractérisé en ce que** le premier élément rotatif en étoile (7) est entraîné et que le deuxième élément rotatif en étoile (9) est entraîné par le premier élément rotatif en étoile.

6. Dispositif d'après l'une des revendications 1 à 5, **caractérisé en ce qu'**au-dessus de des magasins (1-6) est disposé au moins un préhenseur (11,12) qui peut soulever et/ou poser du matériel d'emballage.

7. Dispositif d'après l'une des revendications 1 à 6, **caractérisé en ce que** six magasins (1-6) sont prévus.

8. Dispositif d'après l'une des revendications 1 à 7, **caractérisé en ce qu'**à côté des magasins (1-6) est disposée une desserte, où il est possible de poser ou usiner des objets empilables.

9. Procédé pour le fonctionnement d'un dispositif d'après l'une des revendications 1 à 8 pour l'emballage d'objets empilables, à savoir des plaquettes, en particulier des plaquettes de silicium, dans des réservoirs de transport, **caractérisé en ce que** dans une première position des magasins (1-6) un morceau de matériel d'emballage est enlevé d'un magasin avec du matériel d'emballage, dans une deuxième position le matériel d'emballage prélevé est posé dans un réservoir de transport vide, dans une troisième position une plaquette est posée dans le réservoir de transport rempli maintenant au moyen du robot, dans une quatrième position un autre morceau de matériel d'emballage est enlevé d'un magasin avec du matériel d'emballage, dans une cinquième position le matériel d'emballage prélevé est posé sur la plaquette dans le réservoir de transport.

10. Procédé d'après revendication 9, **caractérisé en ce que** la troisième et quatrième position sont identiques.

11. Procédé pour le fonctionnement d'un dispositif d'après l'une des revendications 1 à 8 pour le déballage d'objets empilables, à savoir des plaquettes, en particulier des plaquettes de silicium, de réservoirs de transport, **caractérisé en ce que** dans une première position des magasins (1-6) un morceau de matériel d'emballage est enlevé d'une caisse de transport, dans une deuxième position le matériel d'emballage prélevé est posé dans un magasin pour du matériel d'emballage, dans une troisième position une plaquette est enlevée du réservoir de transport rempli au moyen du robot, dans une quatrième position un autre morceau de matériel d'emballage est enlevé d'une caisse de transport, dans une cinquième position le matériel d'emballage prélevé est posé dans un magasin pour du matériel d'emballage.

12. Procédé d'après revendication 11, **caractérisé en ce que** la deuxième et troisième position sont identiques.
